# EUROPEAN PATENT SPECIFICATION

(11) **EP 3 687 061 B1**
(45) Date of publication and mention of the grant of the patent: **02.12.2026**
(21) Application number: 19154003.8
(22) Date of filing: 28.01.2019
(51) Int. Cl.: H10F 19/80, H02S 20/23, H02S 30/00, H02S 40/10, H02S 30/10

(54) **DOUBLE-GLASS PHOTOVOLTAIC MODULE AND SOLAR PANEL**
DOPPELGLAS-FOTOVOLTAIKMODUL UND SOLARPANEEL
MODULE PHOTOVOLTAÏQUE À VERRE DOUBLE ET PANNEAU SOLAIRE

(43) Date of publication of application: 29.07.2020
(73) Proprietor: BS60 Solar Innovation GmbH, 12205 Berlin (DE)
(72) Inventor: Podlowski, Lars, 12205 Berlin (DE)
(74) Representative: Eisenführ Speiser

(56) References cited:
- EP-A1- 1 708 280
- WO-A2-2012/012745
- KR-A- 20150 136 718
- US-A1- 2014 261 664
- US-A1- 2017 133 529

## Description

The invention relates to a solar panel and a photovoltaic power station.

Single-glass photovoltaic modules are widely known in the art. In this kind of photovoltaic module, the solar cells are encapsulated between protective films, such as ethylene vinyl acetate (EVA) films, and further protected by a highly transparent front glass sheet of several millimeter thickness, and an electrically insulating flexible foil on the rear side. The laminate is typically mounted to a metal frame with a suitable frame profile clamping the laminate by mechanical pressure. The frame provides mechanical stabilization and edge protection for the laminate. Thus, with this type of photovoltaic module, the laminate or stack comprising the front glass sheet, the solar cells, and the protective backside film are together mounted in the frame to form a solar panel.

In recent years, manufacturers have increasingly pushed the use of double-glass photovoltaic modules. In this type of photovoltaic modules, the solar cells are embedded between two glass sheets, namely, a front glass sheet and a rear glass sheet. An encapsulation of the solar cells by encapsulating films is typically also used. For so-called "bifacial solar cells" double-glass photovoltaic modules allow increasing the active surface area for generating electrical power by additionally using the rear side of the solar cells for electrical power generation. Furthermore, due to the increased mechanical stability of this design in comparison to single-glass modules, mechanical stabilization by a frame is per se not a requirement for double-glass photovoltaic modules. However, a double-glass photovoltaic module is sensitive to receiving damage on the edges of the glass sheets due to improper mechanical handling during transport, installation and maintenance, possibly even resulting in breakage and therefore complete failure of the photovoltaic module.

US 2017/133529 A1 discloses a photovoltaic module including a photovoltaic laminate that includes a transparent front sheet and a rear side cover, one or more solar cells embedded in a embedding material arranged between the transparent front sheet and the rear side cover, and at least one frame profile arranged at one edge of the photovoltaic laminate, wherein at least a portion of the at least one frame profile is adhesively bonded to a portion of the embedding material. At least in one of the embodiments disclosed, the frame profile is formed and bonded to the laminate such that the frame profile substantially does not extend further to a side of the laminate than the surface of the front side sheet or front side cover.

EP 1 708 280 A1 discloses a photovoltaic module which prevents enlargement of the dimensions of a photovoltaic submodule by reducing ineffective parts which do not contribute to power generation.

WO 2012/012745 A2 discloses different embodiments of a sealant material system for use in joining two or more inorganic substrates, for example for the use in a photovoltaic device, that are used to form a hermetic seal protecting an electronic active layer, said sealant material system comprising a solder composition and methods for their production.

KR 2015 0136718 A discloses a solar cell module including a first glass, a second glass, and a sealing material for protecting a unit cell, which is being positioned between the first glass and the second glass. Furthermore, at least one part of the sealing material is protruded to the edge of the second glass and the first glass and can contact one side of the first glass or the second glass.

US 2014/0261664 A1 discloses a photovoltaic cell that includes a transparent substrate that has a first surface and a second surface. A transparent conductive oxide coating resides over the second surface of the transparent substrate. A photovoltaic coating resides over the transparent conductive oxide coating. The photovoltaic cell also includes an anti-reflective coating that resides over the first surface of the transparent substrate. According to the invention, a solar panel comprising a double-glass photovoltaic module according to claim 1 is provided. Preferred embodiments of the solar panel are defined in the dependent claims. The double-glass photovoltaic module comprises a plurality of solar cells embedded between a front glass sheet and a rear glass sheet. In comparison with the front glass sheet, the rear glass sheet exhibits a larger extension, as measured in the rear glass sheet plane. This larger extension is present in at least two spatial directions.

The invention is based on the recognition that improper mechanical handling of a double-glass photovoltaic module during transport, installation and maintenance cannot be safely avoided. Contrary to recent trends in the art, the invention therefore builds on the assumption of continued use of a frame also for double-glass photovoltaic modules.

The inventor has further recognized that cleaning requirements imposed by the use of a frame are inter alia caused by the frame protruding over the glass sheet plane and thus forming a protruding inner frame edge that hinders water drainage from the photovoltaic module, and that in winter also prevents slipping of snow. Thus, particularly where solar panels are mounted at a rather low angle with respect to ground, poor drainage of water and snow results, causing a quick formation of dirt coverage on the active area photovoltaic module, not only near its edges. In absence of frequent cleaning, this would indeed lead to losses in electrical performance during operation. Furthermore, the edge between the front glass sheet and the frame is particularly susceptible to processes such as biofouling. These processes exert a degrading influence on the sealing material, such that, eventually, water may enter the seal and damage the photovoltaic module.

The double-glass photovoltaic module avoids the described disadvantages of using a frame for edge protection and thus allows combining the advantages of edge protection with those of using a double-glass photovoltaic module. By letting the rear glass sheet extend beyond the dimensions of the front glass sheet in at least two spatial directions, the double-glass photovoltaic module according to the invention allows the module to be mounted, i.e, mechanically clamped by the frame profile on only the rear glass sheet. This design therefore achieves that the front glass sheet, in a mounted state, is laterally adjacent to at least parts of an inner edge of the frame. A protrusion of the inner edge of the frame is thus avoided or reduced at least in comparison with known framed module designs, achieving a solar panel with improved drainage in the mounted state. The protrusion of the inner edge of the frame can completely be avoided in some embodiments by proper mutual adaptation of the frame design and the module design.

It is noted that the use of the terms "front glass sheet" and "rear glass sheet" is not intended to imply any restriction in the possible use of the respective glass sheets in operation of the photovoltaic module. In particular, it does not imply that the front glass sheet must be arranged facing the sun in operation of the photovoltaic module. Depending on a desired inclination of the photovoltaic module in operation, the "front glass sheet" can equally be arranged on either the "front side" or on the "back side" of the photovoltaic module in a given installation.

In the following, various embodiments of the double-glass photovoltaic module comprised by the solar panel according to the invention are described.

In a preferred embodiment, the rear glass sheet of the double-glass photovoltaic module has a rectangular shape. This particular shape facilitates an easy and thus, cost efficient mounting of the module, as it allows standard fasteners and, if required, standard frame profiles to be employed, in order to provide a connection between the rear glass sheet and the mounting surface. In one variant of this embodiment, the rear glass sheet has the shape of a square.

In alternative embodiments, the shape of the rear glass sheet of the double-glass photovoltaic module or the entire double-glass photovoltaic module is circular or has any other technologically feasible shape. Even in the case, the rear glass sheet assumes a circular shape, the rear glass sheet can nevertheless be used to mount the entire double-glass photovoltaic module due to its larger extension in comparison with the front glass sheet.

Three different groups of embodiments have different geometries used for implementing the larger extension of the rear glass sheet in comparison with the front glass sheet.

In one of these groups of embodiments, the rear glass sheet of the double-glass photovoltaic module extends beyond opposite edges of the front glass sheet on only two opposite sides thereof. With this embodiment, the advantage is obtained that the photovoltaic module may be mounted safe and securely, utilising the rear glass sheet, with a minimum of fastening means.

In a further group of embodiments, the rear glass sheet of the double-glass photovoltaic module extends beyond edges of the front glass sheet on only two mutually orthogonal sides thereof.

In another, currently preferred group of embodiments, the rear glass sheet of the double-glass photovoltaic module extends beyond all edges of the front glass sheet. With this particular embodiment, it is possible to have a frame lock around the entire rear glass sheet of the double-glass photovoltaic module. This design thus allows achieving a particularly high-level protection of the photovoltaic module against damage potentially done to the module during the transport of the module and/or during mounting and service stages.

From the three different groups of embodiments of the double-glass photovoltaic module highlighted in the above, it is clear that the concept of the double-glass photovoltaic module of the present invention advantageously simplifies not just the mounting procedure, but also increases the flexibility of the photovoltaic module installation and, in addition, minimises the amount of fastening means required. Yet at the same time, the reliability and safety of the photovoltaic module installation is not compromised. And the energy production is increased because modules will remain cleaner.

The glass material used for the front and rear glass sheets is different in different embodiments. In some embodiments, the glass material is a tempered glass, which has the advantage of providing particular mechanical strength compared with normal glass. However, in other embodiments, normal, i.e., untempered glass is used.

In another embodiment, edges of the front glass sheet that face away from the solar cells are polished. Although it is possible to make use of simply machined, i.e., cut or chamfered edges of the front glass sheet in certain other embodiments, polished edges of the present embodiment provide the particular advantage to avoid additional surfaces or edges and improve optical properties. In particular, this additionally avoids a build-up of chemically and/or biologically active agents in the region concerned, such that said agents, water for example, cannot degrade the seal between the front and the rear glass sheet or the photovoltaic module and the fastening means.

In a further embodiment, the plurality of solar cells of the double-glass photovoltaic module is embedded between a top bedding material and a bottom bedding material. This bedding material may be appropriately selected from, but is not limited to, one of the following materials. The bedding may be made from a polymer, such as ethylene-vinyl acetate (EVA), a polyolefin elastomer (POE)-based material, polyvinylbutyral (PVB), ionomers or silicone. In addition, the material selected for the top bedding may differ from the material of the bottom bedding. As the material for the bedding is to be selected from a wide range of materials with differing physical properties, the material may be chosen such that it yields the highest resistance against, for example, water-induced degradation or the like. This, advantageously, provides a high level of flexibility regarding the installation location of the double-glass photovoltaic module and, also a high level of protection of the solar cells from environmental influences.

In a preferred embodiment, the plurality of solar cells of the double-glass photovoltaic module is embedded between a front glass sheet and a rear glass sheet with a clearance in between, whereas the clearance is filled with air or gas. With this particular embodiment, the advantage is acquired that an air- or gas-filled clearance between the front and the rear glass sheet and the solar cells effectively isolates the solar cells. Additionally, an air- or gas-filled clearance may be utilised as a detection means for a compromised photovoltaic module seal. That is, if the pressure in the clearance is sufficiently above or below the ambient pressure, a normalisation of the pressure in the clearance indicates a damaged seal which, in turn, may trigger a service action before the actual solar cells may be damaged.

In some embodiments, the double-glass photovoltaic module of the present invention comprises a bifacial arrangement of the solar cells between the front glass sheet and the rear glass sheet. A monofacial arrangement is used in other embodiments.

The solar panel comprises the double-glass photovoltaic module according to one of the embodiments described above which is mounted in a frame.

It is further provided that the frame comprises a clamping element, clamping only the rear glass sheet and not the front glass sheet of the double-glass photovoltaic module and, it is also provided that the front glass sheet is either flush with a plane defined by inner edges of a front face of the frame or protrudes beyond the front face of the frame.

In assembled form, the double-glass photovoltaic module and the frame form a solar panel, in which clamping of the front glass sheet is not provided. With the solar panel according to the present invention, in contrast, only the rear glass sheet of the double-glass photovoltaic module is clamped and thus supported by the frame in its outer or edge region and thus, the photovoltaic module is fixed in position by means of interaction of the frame engaging with the rear glass sheet alone. This is further accomplished in such a way that the front glass sheet sits either flush with a plane defined by inner edges of a front face of the frame or protrudes beyond the front face of the frame by some margin.

This particular design yields the advantage that, on the one hand, importantly, with a front glass sheet that is flush or protruding relative to the frame, surfaces on which potentially chemically and/or biologically active agents and/or snow may settle are effectively avoided. On the other hand, with the frame partially or entirely locking around the double-glass photovoltaic module, the rigidity of the assembly is improved in comparison with plain double-glass photovoltaic modules. Thus, the solar panel is significantly less prone to damage during transport and installation, whilst also accomplishing that with a minimum of frame profile, if necessary, and thus adding to the flexibility of the solar panel in terms of designated installation locations for example.

In another embodiment, the clamping element clamping exhibits a C-shape. That is, both, the clamping groove of the frame and the outer or edge region of the rear glass sheet, have a complementary, mutually matching C-shape. This design provides the particular advantage that, firstly, during the assembly process, the double-glass photovoltaic module is automatically well aligned with the frame of the solar panel. Secondly, the double-glass photovoltaic module is instantly held tightly in position which, reliably, prevents the glass of the photovoltaic module from chipping due to an undesired motion of module in its frame.

In a further embodiment, the rear glass sheet is additionally secured in the clamping groove by a longer extension of the clamping means on the side of the rear glass sheet. In the case of solar panels of large dimensions, it is desirable to further support the rear glass sheet and thus, the entire double-glass photovoltaic module which adds to the stability of the whole solar panel. This feature provides the advantage that even rather large solar panels may be implemented which results in a higher energy production.

In another preferred embodiment, a gap is formed between an inner surface of the frame and the front glass sheet of the photovoltaic module. This gap is filled with an elastic sealing agent to seal the photovoltaic module against the frame, and the sealing agent is either flush with a front face of the frame or protrudes beyond the plane defined by the inner edges of the front face of the frame, but not beyond a plane defined by a front face of the front glass sheet.

With the sealing agent sitting flush with a front face of the frame and not protruding beyond the front face of the front glass sheet, the seal between the frame and the double-glass photovoltaic module adds to the ability of the solar panel to avoid an undesirable build-up of chemically and/or biologically active agents and/or snow on the solar panel. This gives the advantage of effectively protecting the photovoltaic module against environmental influences, reduction of the number of cleaning cycles required and also extending the lifespan of the seal.

The sealing agent used to fill the gap between the frame and the photovoltaic module may be chosen freely. Preferably, however, the sealing agent may be a ductile rubber material or, may be a viscous sealing material such as a silicon- or acryl-based sealing compound.

In addition, or, alternatively, to the clamping element which aligns the double-glass photovoltaic module with the frame and fixes it in position relative to the frame, the photovoltaic module may be glued into the frame. In accordance with the invention, it is possible to employ the same glue/sealing agent to fix the photovoltaic module in position and to seal the gap between the frame and the module. This may further be accomplished in a single process step or, may be done in two separate process steps. That is, the photovoltaic module may be first glued into the frame and, subsequently, the gap may be filled with the chosen sealing agent or glue and vice versa.

Furthermore, a photovoltaic power station according to claim 12 is provided.

The photovoltaic power station comprises at least one solar panel according to the invention.

The photovoltaic power station shares the advantages of the solar panel as described herein.

In the following, further embodiments will be described with reference to the Figures.

In the Figures:
- Fig. 1A: shows a schematic side view of an embodiment of a double-glass photovoltaic module, comprising a plurality of solar cells, embedded between a front glass sheet and a rear glass sheet;
- Fig. 1B: shows a top view of a variant of the double-glass photovoltaic module of Fig. 1 (A);
- Fig. 2: shows a section-view of an embodiment of a solar panel comprising frame a double-glass photovoltaic module, with a detailed view (S) annotated;
- Fig. 3: shows a C-shaped clamping element, formed of the rear glass sheet of the double-glass photovoltaic module and the frame;
- Fig. 4: shows the solar panel with the gap filled with an elastic sealing agent, to seal the photovoltaic module against the frame and a bracket element, to fasten the photovoltaic module to a surface.

For simplicity, in the Figures, those details of the structure of the respective embodiments double-glass photovoltaic module, which are not required for conveying their main features, are not shown. Furthermore, even though different variants are shown throughout the Figures, some of the reference labels used are identical where appropriate to allow an easier identification of like features in the different variants.

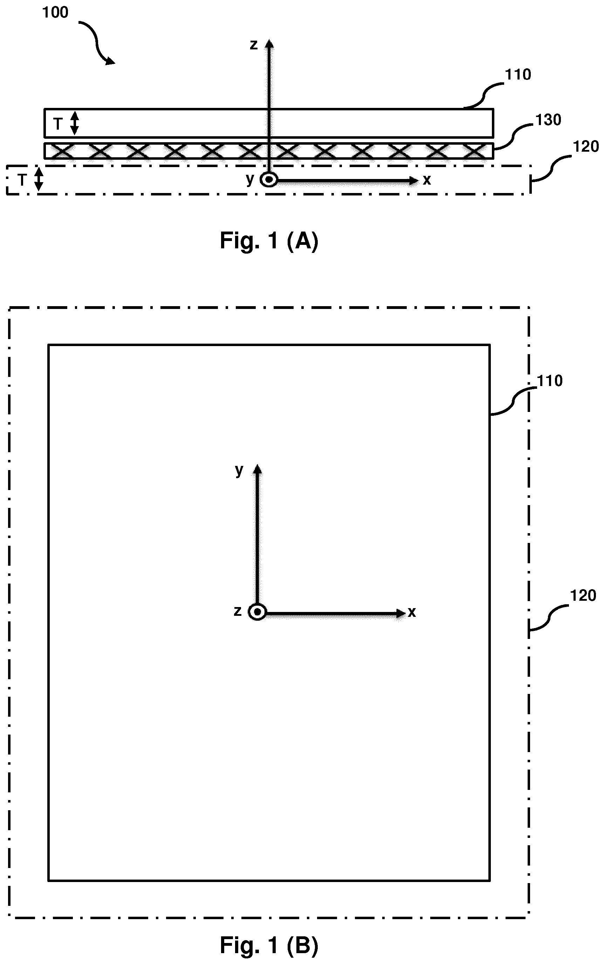

Figure 1A shows a schematic side view of an embodiment of a double-glass photovoltaic module 100, comprising a plurality of solar cells 130, embedded between a front glass sheet 110 and a rear glass sheet 120. The rear glass sheet 120 is shown as a dotdashed line, in order to highlight the fact that that the rear glass sheet 120 exhibits a larger extension than the front glass sheet 110, in at least two spatial directions, as measured in the rear glass sheet plane. In accordance with Figure 1A that larger extension of the rear glass sheet is shown in the positive and the negative x-direction. For simplicity, those details of the structure of the double-glass photovoltaic module 100, which are not required for conveying main features of the present invention, are not shown.

In the variant of Figure 1B, on the other hand, as visible in a top view of the double-glass photovoltaic module 100, whereas the plurality of solar cells 130 is not visible. Figure 1B shows the embodiment, where the rear glass sheet 120 extends beyond all edges of the front glass sheet 110. According to Figure 1B that is in the positive and the negative x- and y-direction.

Furthermore, commonly, the thickness (T) of the front glass sheet 110 is equal to the thickness (T) of the rear glass sheet 120. In some cases, however, it may be advantageous to specify the front glass sheet to be thicker than the rear glass sheet and vice versa. Those cases may be, where the thickness of the front glass sheet is reduced to a minimum to reduce the overall weight of the photovoltaic module, but the rear glass sheet has to maintain a certain, predefined thickness to match the clamping element 220 of the frame 210.

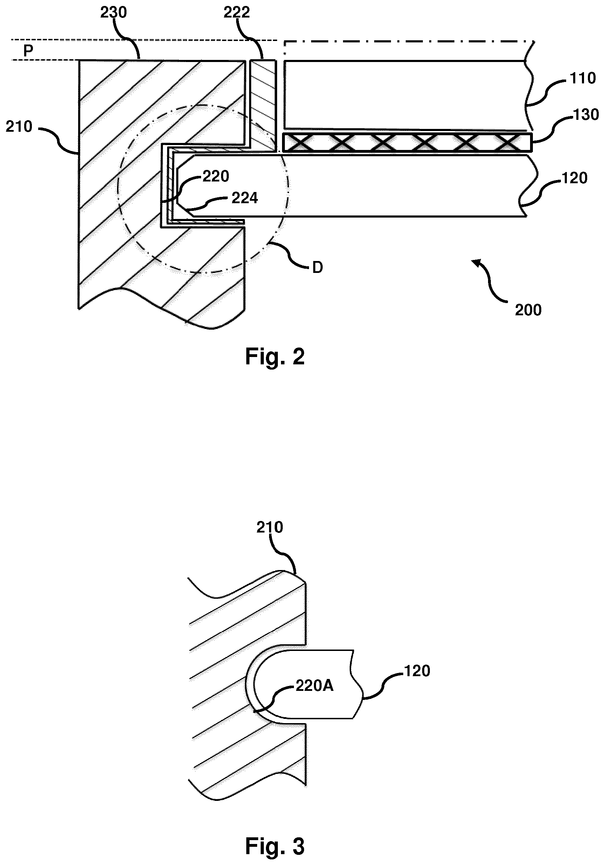

Figure 2 shows a simplified, more detailed section-view of the solar panel 200, comprising the double-glass photovoltaic module 100 and a corresponding frame 210. For reasons of simplicity, further layers that may be used, for instance for encapsulation of the solar cells, are omitted in Fig. 2. In this section-view, the front glass sheet 110 of the double-glass photovoltaic module 100 is denoted together with the rear glass sheet 120, the plurality of solar cells 130, the frame 210 of the solar panel and the clamping element 220, clamping only the rear glass sheet 120, which in Fig. 2 is shown with simple chamfered edges 224, reducing the sensitivity of the edges against damage and aiding to prevent cuts and thus, increasing safety for the installation personnel. In addition, in Figure 2 an optional protrusion (P) of the front glass sheet is schematically shown in dotdashed lines, whereas this glass sheet is either flush with a plane defined by inner edges of a front face 230 of the frame 210 or protrudes beyond the front face of the frame.

A fixation of the double glass photovoltaic module in the frame 210 using only the rear glass sheet 120 is highlighted in Figure 2 by a dash-dotted circle D.

A sealing agent 222, which is suitably made of an elastomer, seals any remaining space between the photovoltaic module 100 and the frame 210. Other suitable sealing agents are per se known in the art. Alternatively, a glue may be used for a particularly strong fixation of the module in the frame.

A sealing procedure can be carried out in a single process step or in two consecutive process steps.

In the former case, an excess of sealing agent, suitably in a liquid or viscous state, is inserted into the clamping element 220. Subsequently, the double-glass photovoltaic module 100 is pressed into the clamping element, causing excess sealing agent to be squeezed out of the clamping element 220 and filling the space extending between the front glass sheet 110 and the frame 210. With this method, the double-glass photovoltaic module 100 is fixed in and sealed against the frame 210 in one process step.

Alternatively, in the latter case, the double-glass photovoltaic module 100 is fixed in the frame 210 first and, subsequently, is sealed against the frame 210 thus, using two process steps.

Figure 3 shows a detailed view of an alternative embodiment of the clamping element 220 of the solar panel 200. Fig. 3 is a detailed view restricted in scope to a section corresponding to that indicated by the circle D in Fig. 2 for the above embodiment of the solar panel. In the embodiment shown the clamping element 220A exhibits a C-shape, forming a C-shaped clamping groove. From Figure 3, it can be seen that this design provides the particular advantages that the rear glass sheet 120 of the double-glass photovoltaic module 100 is automatically well aligned with the frame 210 of the solar panel 200 and, that the double-glass photovoltaic module 100 is instantly held tightly in position which prevents the glass of the photovoltaic module from chipping due to an undesired motion of module in its frame.

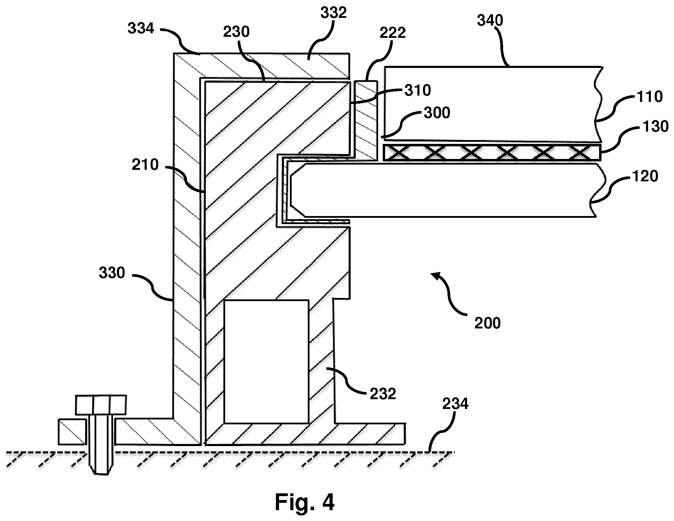

In Figure 4, a detailed section-view of the solar panel 200 is shown. It is illustrated that a gap 300 is formed between an inner surface 310 of the frame 210 and the front glass sheet 110 of the double-glass photovoltaic module 100. The present Figure also shows a bracing means 232 forming a lower part of the frame 210. The bracing means 232 is formed by a hollow profile segment commonly employed to mount the solar panel 200 on roof top surfaces 234 and similar installation locations of solar panels, in conjunction with a bracket element 330, required to establish a, for example, friction-locked connection between the frame 210 and the roof top surface 234, through pressing the frame against the surface.

In the embodiment shown in Fig. 4, the bracket element 330 further has a clamping means 332 that substantially matches an extension of the front face 230 of the frame 210. Therefore, the clamping means 332 does not reach across the front face 340 of the front glass sheet 110 of the double-glass photovoltaic module 100 thus, preventing damage potentially done to the front glass sheet 110, due to a component commonly made from metal clamping down on glass. In addition, it is also possible to further increase the thickness of the front glass sheet, such that it also protrudes beyond the front face 334 of the bracket element 330. This measure can help, avoiding a localised build-up of snow for example, as the front face 340 of the front glass sheet 110 onto which snow may settle, vertically extends beyond the front face 334 of the bracket element 330.

For reasons of simplicity, only one of the potentially feasible fastening methods of a solar panel 200 is described in the above. For differing fastening methods, similar advantages can be obtained however.

Fig. 4 further shows that the gap 300 is filled with an elastic sealing agent 222 or, alternatively, glue, to seal the photovoltaic module 100 against the frame 210 as is pointed out above. Importantly, the sealing agent 222 is either flush with a front face 230 of the frame 210 or, protrudes beyond the plane defined by the inner edges of the front face of the frame 230, but not beyond a plane defined by a front face 340 of the front glass sheet 110.

## Claims

1. A solar panel (200), comprising
- a double-glass photovoltaic module (100) comprising
- a plurality of solar cells (130) embedded between a front glass sheet (110) and a rear glass sheet (120), wherein
- the rear glass sheet (120) exhibits a larger extension than the front glass sheet (110), in at least two spatial directions, as measured in the rear glass sheet plane;
- a frame (210), in which the double-glass photovoltaic module (100) is mounted;
- the front glass sheet (110) is either flush with a plane defined by inner edges of a front face (230) of the frame (210) or protrudes beyond the front face (230) of the frame (210), **characterized in that**
- the frame (210) comprises a clamping element (220; 220A) clamping only the rear glass sheet (120) and not the front glass sheet (110) of the double-glass photovoltaic module (100).

2. The solar panel (200) according to claim 1, wherein the rear glass sheet (120) has a rectangular shape.

3. The solar panel (200) according to claim 1 or 2, wherein the rear glass sheet (120) extends beyond opposite edges of the front glass sheet (110) on only two opposite sides thereof.

4. The solar panel (200) according to claim 1 or 2, wherein the rear glass sheet (120) extends beyond edges of the front glass sheet (110) on only two mutually orthogonal sides thereof.

5. The solar panel (200) according to claim 1 or 2, wherein the rear glass sheet (120) extends beyond all edges of the front glass sheet (110).

6. The solar panel (200) according to one of the preceding claims, wherein edges of the front glass sheet (110) that face away from the solar cells (130) are polished.

7. The solar panel (200) according to one of the preceding claims, wherein the plurality of solar cells (130) is embedded between a top bedding material and a bottom bedding material.

8. The solar panel (200) according to one of the preceding claims, wherein the plurality of solar cells (130) is embedded between a front glass sheet (110) and a rear glass sheet (120) with a clearance in between and the clearance is filled with air or gas.

9. The solar panel (200) according to one of the preceding claims, comprising a bifacial arrangement of the solar cells (130) between the front glass sheet (110) and the rear glass sheet (120).

10. The solar panel (200) according to one of the preceding claims, wherein the clamping element (220A) clamping the rear glass sheet (120) exhibits a C-shape, forming a clamping groove.

11. The solar panel (200) according to one of the preceding claims, wherein the rear glass sheet (120) is additionally secured in the clamping groove by a clamping means (332).

12. The solar panel (200) according to one of the preceding claims, wherein
- a gap (300) is formed between an inner surface (310) of the frame (210) and the front glass sheet (110) of the photovoltaic module (100), and
- the gap (300) is filled with an elastic sealing agent (222) to seal the photovoltaic module against the frame (210), and the sealing agent (222) is either flush with a front face (230) of the frame (210) or protrudes beyond the plane defined by the inner edges of the front face (230) of the frame (210), but not beyond a plane defined by a front face (340) of the front glass sheet (110).

13. A photovoltaic power station, having at least one solar panel (200) according to one of the claims 1 to 12, wherein the front glass sheet (110) of the at least one solar panel (200) is arranged facing the sun in operation of the photovoltaic power station.

## Patentansprüche

1. Solarpanel (200), umfassend
- ein Doppelglas-Photovoltaikmodul (100), umfassend
- eine Mehrzahl von Solarzellen (130), die zwischen einer vorderen Glasscheibe (110) und einer hinteren Glasscheibe (120) eingebettet sind, wobei
- die hintere Glasscheibe (120) in mindestens zwei Raumrichtungen, gemessen in der Ebene der hinteren Glasscheibe, eine größere Ausdehnung aufweist als die vordere Glasscheibe (110);
- einen Rahmen (210), in dem das Doppelglas-Photovoltaikmodul (100) montiert ist;
- die vordere Glasscheibe (110) entweder bündig mit einer Ebene ist, die durch Innenkanten einer Vorderseite (230) des Rahmens (210) definiert ist, oder über die Vorderseite (230) des Rahmens (210) hinausragt, **dadurch gekennzeichnet, dass**
- der Rahmen (210) ein Klemmelement (220; 220A) umfasst, das nur die hintere Glasscheibe (120) und nicht die vordere Glasscheibe (110) des Doppelglas-Photovoltaikmoduls (100) klemmt.

2. Solarpanel (200) nach Anspruch 1, wobei die hintere Glasscheibe (120) eine rechteckige Form aufweist.

3. Solarpanel (200) nach Anspruch 1 oder 2, wobei sich die hintere Glasscheibe (120) über gegenüberliegende Kanten der vorderen Glasscheibe (110) hinaus nur an zwei gegenüberliegenden Seiten davon erstreckt.

4. Solarpanel (200) nach Anspruch 1 oder 2, wobei sich die hintere Glasscheibe (120) über Kanten der vorderen Glasscheibe (110) hinaus nur an zwei zueinander orthogonalen Seiten davon erstreckt.

5. Solarpanel (200) nach Anspruch 1 oder 2, wobei sich die hintere Glasscheibe (120) über alle Kanten der vorderen Glasscheibe (110) hinaus erstreckt.

6. Solarpanel (200) nach einem der vorhergehenden Ansprüche, wobei Kanten der vorderen Glasscheibe (110), die den Solarzellen (130) abgewandt sind, poliert sind.

7. Solarpanel (200) nach einem der vorhergehenden Ansprüche, wobei die Mehrzahl von Solarzellen (130) zwischen einer oberen Einbettungsschicht und einer unteren Einbettungsschicht eingebettet ist.

8. Solarpanel (200) nach einem der vorhergehenden Ansprüche, wobei die Mehrzahl von Solarzellen (130) zwischen einer vorderen Glasscheibe (110) und einer hinteren Glasscheibe (120) mit einem Zwischenraum dazwischen eingebettet ist und der Zwischenraum mit Luft oder Gas gefüllt ist.

9. Solarpanel (200) nach einem der vorhergehenden Ansprüche, umfassend eine bifaziale Anordnung der Solarzellen (130) zwischen der vorderen Glasscheibe (110) und der hinteren Glasscheibe (120).

10. Solarpanel (200) nach einem der vorhergehenden Ansprüche, wobei das Klemmelement (220A), das die hintere Glasscheibe (120) klemmt, eine C-Form aufweist, die eine Klemmnut bildet.

11. Solarpanel (200) nach einem der vorhergehenden Ansprüche, wobei die hintere Glasscheibe (120) zusätzlich in der Klemmnut durch ein Klemmmittel (332) gesichert ist.

12. Solarpanel (200) nach einem der vorhergehenden Ansprüche, wobei
- ein Spalt (300) zwischen einer Innenfläche (310) des Rahmens (210) und der vorderen Glasscheibe (110) des Photovoltaikmoduls (100) ausgebildet ist, und
- der Spalt (300) mit einem elastischen Dichtmittel (222) gefüllt ist zum Abdichten des Photovoltaikmoduls gegen den Rahmen (210), und das Dichtmittel (222) entweder bündig mit einer Vorderseite (230) des Rahmens (210) ist oder über die Ebene hinausragt, die durch die Innenkanten der Vorderseite (230) des Rahmens (210) definiert ist, jedoch nicht über eine Ebene hinaus, die durch eine Vorderseite (340) der vorderen Glasscheibe (110) definiert ist.

13. Photovoltaikkraftwerk, aufweisend mindestens ein Solarpanel (200) nach einem der Ansprüche 1 bis 12, wobei die vordere Glasscheibe (110) des mindestens einen Solarpanels (200) im Betrieb des Photovoltaikkraftwerks der Sonne zugewandt angeordnet ist.

## Revendications

1. Panneau solaire (200), comprenant
- un module photovoltaïque à double verre (100) comprenant
- une pluralité de cellules solaires (130) noyées entre une plaque de verre avant (110) et une plaque de verre arrière (120), dans lequel
- la plaque de verre arrière (120) présente une étendue plus grande que la plaque de verre avant (110), dans au moins deux directions spatiales, mesurée dans le plan de la plaque de verre arrière ;
- un cadre (210), dans lequel le module photovoltaïque à double verre (100) est monté ;
- la plaque de verre avant (110) est soit affleurante à un plan défini par des bords intérieurs d'une face avant (230) du cadre (210), soit dépasse de la face avant (230) du cadre (210), **caractérisé en ce que**
- le cadre (210) comprend un élément de serrage (220 ; 220A) serrant uniquement la plaque de verre arrière (120) et non la plaque de verre avant (110) du module photovoltaïque à double verre (100).

2. Panneau solaire (200) selon la revendication 1, dans lequel la plaque de verre arrière (120) a une forme rectangulaire.

3. Panneau solaire (200) selon la revendication 1 ou 2, dans lequel la plaque de verre arrière (120) s'étend au-delà de bords opposés de la plaque de verre avant (110) sur seulement deux côtés opposés de celle-ci.

4. Panneau solaire (200) selon la revendication 1 ou 2, dans lequel la plaque de verre arrière (120) s'étend au-delà de bords de la plaque de verre avant (110) sur seulement deux côtés mutuellement orthogonaux de celle-ci.

5. Panneau solaire (200) selon la revendication 1 ou 2, dans lequel la plaque de verre arrière (120) s'étend au-delà de tous les bords de la plaque de verre avant (110).

6. Panneau solaire (200) selon l'une des revendications précédentes, dans lequel des bords de la plaque de verre avant (110) qui sont opposés aux cellules solaires (130) sont polis.

7. Panneau solaire (200) selon l'une des revendications précédentes, dans lequel la pluralité de cellules solaires (130) est noyée entre un matériau d'enrobage supérieur et un matériau d'enrobage inférieur.

8. Panneau solaire (200) selon l'une des revendications précédentes, dans lequel la pluralité de cellules solaires (130) est noyée entre une plaque de verre avant (110) et une plaque de verre arrière (120) avec un espace intermédiaire entre celles-ci et l'espace intermédiaire est rempli d'air ou de gaz.

9. Panneau solaire (200) selon l'une des revendications précédentes, comprenant un agencement bifacial des cellules solaires (130) entre la plaque de verre avant (110) et la plaque de verre arrière (120).

10. Panneau solaire (200) selon l'une des revendications précédentes, dans lequel l'élément de serrage (220A) serrant la plaque de verre arrière (120) présente une forme en C, formant une rainure de serrage.

11. Panneau solaire (200) selon l'une des revendications précédentes, dans lequel la plaque de verre arrière (120) est fixée en outre dans la rainure de serrage par un moyen de serrage (332).

12. Panneau solaire (200) selon l'une des revendications précédentes, dans lequel
- un interstice (300) est formé entre une surface intérieure (310) du cadre (210) et la plaque de verre avant (110) du module photovoltaïque (100), et
- l'interstice (300) est rempli d'un agent d'étanchéité élastique (222) pour étancher le module photovoltaïque contre le cadre (210), et l'agent d'étanchéité (222) est soit affleurant à une face avant (230) du cadre (210), soit dépasse au-delà du plan défini par les bords intérieurs de la face avant (230) du cadre (210), mais pas au-delà d'un plan défini par une face avant (340) de la plaque de verre avant (110).

13. Centrale photovoltaïque, ayant au moins un panneau solaire (200) selon l'une des revendications 1 à 12, dans laquelle la plaque de verre avant (110) de l'au moins un panneau solaire (200) est agencée orientée vers le soleil en fonctionnement de la centrale photovoltaïque.
